# EUROPÄISCHE PATENTSCHRIFT

(11) **EP 1 200 846 B1**
(45) Veröffentlichungstag und Bekanntmachung des Hinweises auf die Patenterteilung: **15.10.2003**
(21) Anmeldenummer: 00960342.4
(22) Anmeldetag: 04.08.2000
(51) Int. Cl.: G01R 31/00, G01R 31/28

(54) **AKTORANORDNUNG, INSBESONDERE ZUR ANSTEUERUNG EINES EINSPRITZVENTILS EINER BRENNKRAFTMASCHINE**
ACTUATOR ARRANGEMENT, ESPECIALLY FOR CONTROLLING AN INJECTION VALVE IN AN INTERNAL COMBUSTION ENGINE
ENSEMBLE ACTIONNEUR, SERVANT NOTAMMENT A COMMANDER UNE SOUPAPE D'INJECTION D'UN MOTEUR A COMBUSTION INTERNE

(30) Priorität: 05.08.1999 DE 19936858
(43) Veröffentlichungstag der Anmeldung: 02.05.2002
(73) Patentinhaber: SIEMENS AKTIENGESELLSCHAFT, 80333 München (DE)
(72) Erfinder: BOLZ, Stephan, D-93102 Pfatter (DE); SASS, Dieter, D-93059 Regensburg (DE)
(86) Internationale Anmeldenummer: DE0002663
(87) Internationale Veröffentlichungsnummer: WO01011378

(56) Entgegenhaltungen:
- DE-A- 3 616 975
- US-A- 4 839 812
- US-A- 4 884 033

## Beschreibung

Die Erfindung betrifft eine Aktoranordnung, insbesondere zur Ansteuerung eines Einspritzventils einer Brennkraftmaschine, gemäß dem Oberbegriff des Anspuchs 1.

Es sind Brennkraftmaschinen mit Einspritzanlagen bekannt, bei denen die Betätigung der Einspritzventile durch Aktoren erfolgt, die von einer Endstufe mit einem Leistungstransistor elektrisch angesteuert werden, wobei die Endstufe von dem Aktor getrennt ausgeführt und mit diesem über ein Kabel verbunden ist.

Es sind weiterhin Aktoren bekannt, bei denen die Endstufe in den Aktor integriert ist, wodurch die Kabelverbindung zwischen Aktor und Endstufe entfällt, so daß der Aktor über eine Steuerleitung direkt mit der Motorsteuerung verbunden werden kann. In der Motorsteuerung ist dann anstelle der Endstufe nur noch ein Leitungstreiber erforderlich, wobei der Leitungstreiber in der Lage ist, Fehler auf der Steuerleitung zwischen der Motorsteuerung und dem Aktor zu erkennen. Bei einer Unterbrechung oder einem Kurzschluß der Steuerleitung kann die Motorsteuerung deshalb sofort geeignete Maßnahmen einleiten. Eine Fehlerdiagnose der in den Aktor integrierten Endstufe ist jedoch durch den Leitungstreiber in der Motorsteuerung nicht möglich.

Es sind deshalb sogenannte intelligente Aktoren bekannt, die Diagnosefähigkeiten aufweisen, um den Betriebszustand des Aktors und der Endstufe zu überwachen. So können im Betrieb einer derartigen intelligenten Aktoranordnung beispielsweise Kurzschlüsse nach Masse bzw. Batteriespannung, Unterbrechungen im Aktor, Ausfall des der Endstufe oder ein Verlust der Versorgungsspannng erkannt werden. Hierzu ist eine Diagnoseschaltung in den Aktor integriert, die Ausgangsstrom und -spannung mißt und mit vorgegebenen Referenzwerten vergleicht. Beim Erkennen eines Fehler gibt die Diagnoseschaltung dann ein entsprechendes Signal auf einer separaten Leitung an die Motorsteuerung.

Nachteilig an derartigen intelligenten Aktoren ist die Tatsache, daß zur Rückmeldung des Betriebszustands an die Motorsteuerung eine separate Leitung erforderlich ist.

Der Erfindung liegt deshalb die Aufgabe zugrunde, ein intelligente Aktoranordnung mit einer integrierten Endstufe und Diagnosefähigkeiten zu schaffen, wobei zur Rückmeldung des Betriebszustands an die Motorsteuerung keine separate Leitung erforderlich ist.

Die Aufgabe wird, ausgehend von der vorstehend beschriebenen bekannten intelligenten Aktoranordung, durch die kennzeichnenden Merkmale des Anspruchs 1 gelöst.

Die Erfindung schließt die allgemeine technische Lehre ein, den Betriebszustand der intelligenten Aktoranordnung über die ohnehin vorhandene Steuerleitung zu der Motorsteuerung zu übertragen, so daß auf eine separate Leitung zur Rückmeldung des Betriebszustands verzichtet werden kann.

Die Rückmeldung des Betriebszustands von der intelligenten Aktoranordnung zu der Motorsteuerung erfolgt hierbei vorzugsweise durch die Beeinflussung des Eingangsverhaltens der Aktoranordnung in Abhängigkeit vom aktuellen Betriebszustand. Der Begriff Eingangsverhalten ist hierbei und im folgenden allgemein zu verstehen und umfaßt alle Zustandsgrößen am Steuereingang der intelligenten Aktoranordnung, die über die Steuerleitung von der Motorsteuerung erfaßt werden können und damit eine Rückmeldung von der intelligenten Aktoranordnung zu der Motorsteuerung ermöglichen.

In einer Variante der Erfindung erfolgt die zustandsabhängige Änderung des Eingangsverhaltens, indem die Eingangsimpedanz des Steuereingangs 4 verändert wird. Hierzu kann die Steuerleitung in der intelligenten Aktoranordnung beispielsweise über Widerstände und Schaltelemente mit Masse verbunden werden. Die Motorsteuerung kann dann den Leitungswiderstand auf der Steuerleitung messen und daraus den Betriebszustand der Aktoranordnung ermitteln. Anstelle von Widerständen kann die Steuerleitung auch über andere Bauelemente, wie beispielsweise Kondensatoren oder Induktivitäten, mit Masse oder Batteriespannung verbunden werden. Die Eingangsimpedanz der Aktoranordnung kann auch in mehreren Stufen verändert werden, um der Motorsteuerung mehrere Betriebszustände signalisieren zu können. Dies kann beispielsweise dadurch geschehen, daß die Steuerleitung in der Aktoranordnung über mehrere Widerstände und entsprechende Schaltelemente mit Masse verbunden wird, wobei die einzelnen Widerstände unterschiedliche Widerstandswerte aufweisen.

Neben der vorstehend beschriebenen passiven Änderung des Eingangsverhaltens ist es jedoch auch möglich, das Eingangsverhalten aktiv zu beeinflussen. Dies kann beispielsweise geschehen, in dem die Steuerleitung in der Aktoranordnung über ein Schaltelement mit der Batteriespannung verbunden wird. Die Motorsteuerung erkennt dann an der Spannung auf der Steuerleitung den Betriebszustand der intelligenten Aktoranordnung. Die Rückmeldung des Betriebszustands von der Aktoranordnung zu der Motorsteuerung kann auch erfolgen, indem eine bidirektionale Datenübertragung auf der Steuerleitung erfolgt, soweit die Anforderung des Echtzeitbetriebs der Aktoranordnung das zuläßt. Bei einer digitalen Datenübertragung ist dies beispielsweise im Rahmen eines Vollduplex- oder Halbduplex-Betriebs möglich. Bei einer analogen Datenübertragung zwischen der Aktoranordnung und der Motorsteuerung kann das Rückmeldungssignal dagegen in einem anderen Frequenzbereich übertragen werden als das von der Motorsteuerung erzeugte Steuersignal. Die Trennung des Steuersignals von dem Rückmeldungssignal kann dabei in einfacher Weise durch entsprechend abgestimmte Bandpaßfilter erfolgen.

Gemeinsam ist den vorstehend beschriebenen Arten der Beeinflussung des Eingangsverhaltens, daß der Steuereingang in der intelligenten Aktoranordnung mit einem steuerbaren Schaltelement verbunden ist. Die Ansteuerung des Eingangsverhaltens erfolgt hierbei durch eine Diagnoseschaltung, die ausgangsseitig mit dem Schaltelement am Steuereingang verbunden ist, um das Eingangsverhalten der Aktoranordnung in Abhängigkeit vom Betriebszustand zu beeinflussen.

In der bevorzugten Ausführungsform der Erfindung besteht die Diagnoseschaltung aus einer Vergleichereinheit und einer nachgeschalteten Logikschaltung. Die Vergleichereinheit ist hierbei eingangsseitig mit der Endstufe und/oder mit dem Aktor selbst verbunden und mißt an diesen Meßpunkten Strom und/oder Spannung. Anschließend werden die Meßwerte in der Vergleichereinheit mit vorgegebenen Referenzwerten verglichen, um den Betriebszustand der Aktoranordnung zu analysieren. Ausgangsseitig steuert die Vergleichereinheit dann die Logikschaltung an, die in Abhängigkeit vom Betriebszustand mehrere Schaltelemente am Steuereingang der Aktoranordnung aktiviert und dadurch die Eingangsimpedanz am Steuereingang bestimmt.

Die erfindungsgemäße intelligente Aktoranordnung eignet sich besonders vorteilhaft für den Einsatz in einer Einspritzanlage einer Brennkraftmaschine, wobei insbesondere eine Common-Rail-Einspritzanlage zu nennen ist. Die Erfindung ist jedoch nicht auf dieses Einsatzgebiet beschränkt. Vielmehr läßt sich das erfindungsgemäße Prinzip eines intelligenten Aktors mit einer Ferndiagnosemöglichkeit über die ohnehin vorhandene Steuerleitung auch in anderen Bereichen der Technik verwenden.

Andere vorteilhafte Weiterbildungen der Erfindung sind in den Unteransprüchen gekennzeichnet bzw. werden nachstehend zusammen mit der Beschreibung der bevorzugten Ausführungsform der Erfindung anhand der Figur näher dargestellt. Es zeigt:

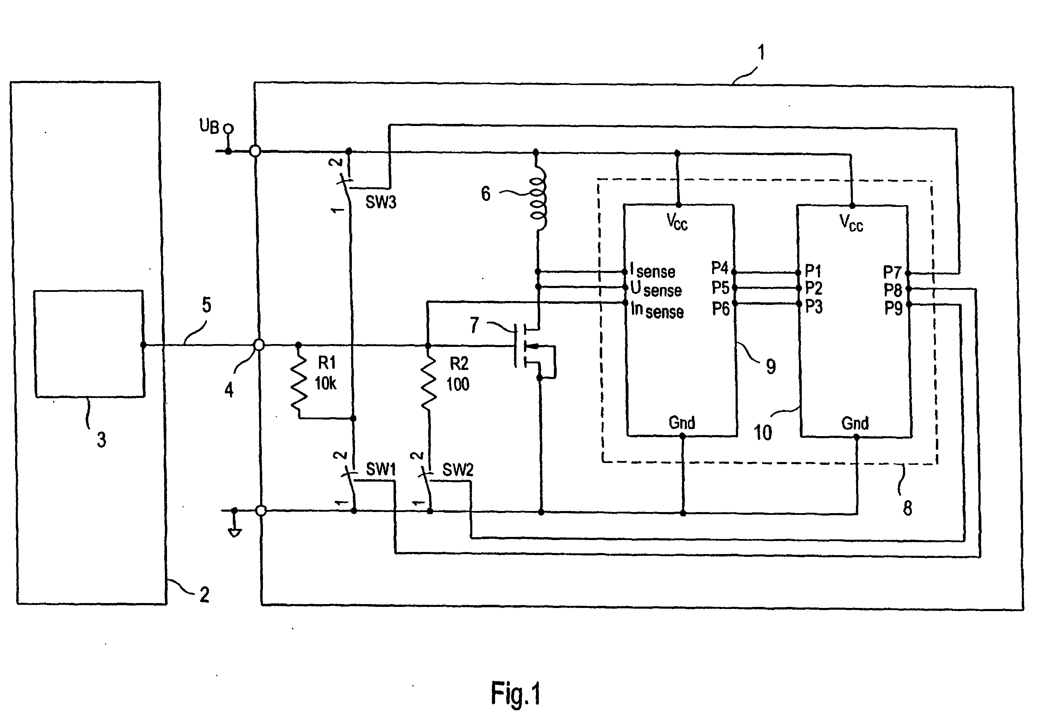

- Figur 1: ein Schaltbild einer erfindungsgemäßen intelligenten Aktoranordnung mit einer Motorsteuerung.

Das in Figur 1 dargestellte Schaltbild zeigt eine erfindungsgemäße Aktoranordnung 1 zur Ansteuerung eines Einspritzventils einer Brennkraftmaschine.

Im folgenden wird zunächst der strukturelle Aufbau der Schaltung beschrieben, um anschließend unter Bezugnahme auf die Beschreibung des Schaltungsaufbaus die Funktionsweise der erfindungsgemäßen Anordnung zu erläutern.

Die Aktoranordnung 1 wird über eine nur schematisch dargestellte Motorsteuerung 2 mit einem Leitungstreiber 3 angesteuert, wobei der Leitungstreiber 3 eine vollständige Diagnose des Leitungszustands in Bezug auf Unterbrechung und niederohmige Kurzschlüsse zu Masse oder Betriebsspannung erlaubt. Zum Anschluß an die Motorsteuerung 2 weist die Aktoranordnung 1 einen Steuereingang 4 auf, der über eine Steuerleitung 5 mit dem Leitungstreiber 3 verbunden ist.

Die mechanische Betätigung des Einspritzventils erfolgt hierbei durch einen Aktor mit einer Erregerspule 6, wobei der eine Anschluß der Erregerspule 6 mit Batteriespannung U_{B} und der andere Anschluß mit dem Drain-Anschluß eines Endstufen-Transistors 7 verbunden ist. Der Source-Anschluß des Endstufentransistors 7 ist direkt mit Masse verbunden, so daß der Aktor und damit auch das Einspritzventil beim Durchschalten des Endstufen-Transistors 7 aktiviert wird. Der Gate-Anschluß des Endstufen-Transistors 7 ist mit dem Steuereingang 4 verbunden, so daß der Leitungstreiber 3 den Endstufentransistor 7 ansteuern kann.

Darüber hinaus ist der Steuereingang 4 über eine Reihenschaltung aus einem ersten Widerstand R1=10 kΩ und einem ersten Schalter SW1 mit Masse verbunden, so daß sich der Eingangswiderstand des Steuereingangs 4 durch den Schalters SW1 ändern läßt.

Weiterhin ist der Steuereingang 4 über eine Reihenschaltung aus einem zweiten Widerstand R2=100 Ω und einem zweiten Schalter SW2 mit Masse verbunden, so daß sich der Eingangswiderstand in Abhängigkeit von der Stellung der beiden Schalter SW1, SW2 in mehreren Stufen verändern läßt.

Schließlich ist noch ein dritter Schalter SW3 vorgesehen, der mit einem Anschluß mit Batteriespannung U_{B} und mit dem anderen Anschluß mit dem Verbindungspunkt des ersten Schalters SW1 und des ersten Widerstands R1 verbunden ist, so daß der Steuereingang 4 über eine Reihenschaltung aus dem ersten Widerstand R1 und dem dritten Schalter SW3 mit der Batteriespannung U_{B} verbunden ist, um den Steuereingang 4 zur Signalisierung des Betriebszustands auf die Batteriespannung U_{B} legen zu können.

Zur Ansteuerung der drei Schalter SW1, SW2 und SW3 ist eine Diagnoseschaltung 8 vorgesehen, die aus einer Vergleichereinheit 9 und einer Logikschaltung 10 besteht.

Die Logikschaltung 10 weist drei digitale Ausgänge P7, P8 und P9 auf, die mit den Steuereingängen der drei Schalter SW2, SW1, SW3 verbunden sind. Darüber hinaus weist die Logikschaltung 10 einen mit Batteriespannung verbundenen Stromversorgungsanschluß V_{CC} und einen mit Masse verbundenen Masseanschluß GND auf. Schließlich verfügt die Logikschaltung 10 über drei digitale Eingänge P1, P2 und P3, die das Ausgangssignal an den drei Ausgängen P7, P8 und P9 bestimmen.

Die Vergleichereinheit 9 verfügt über drei Meßeingänge I_{SENSE}, U_{SENSE} und IN_{SEMSE}, um den Betriebszustand der Aktoranordnung zu erfassen. Der Meßeingang IN_{SENSE} ist mit dem Steuereingang 4 verbunden und erfaßt somit das Steuersignal der Motorsteuerung 2. Der Meßeingang U_{SENSE} ist dagegen mit dem Drain-Anschluß des Endstufentransistors 7 verbunden und erfaßt somit die Spannung über dem Endstufentransistor 7, während der Meßeingang I_{SENSE} mit dem Verbindungspunkt der Erregerspule 6 mit dem Endstufen-Transistor 7 verbunden ist und somit indirekt den Strom durch den Endstufen-Transistor 7 und damit auch durch die Erregerspule 6 bestimmt. Darüber hinaus weist die Vergleichereinheit 9 einen mit Batteriespannung verbundenen Stromversorgungsanschluß V_{CC} und einen mit Masse verbundenen Masseanschluß GND auf. Die Vergleichereinheit 9 vergleicht die über die Meßeingänge I_{SENSE}, U_{SENSE} und IN_{SENSE} aufgenommenen Meßwerte intern mit vorgegebenen Referenzwerten und gibt in Abhängigkeit von dem Vergleichsergebnis an drei digitalen Ausgängen P4, P5 und P6 entsprechende Digitalsignale aus, wobei die Ausgänge P4, P5 und P6 mit den Eingängen P1, P2 und P3 der Logikschaltung 10 verbunden sind.

Im folgenden wird nun unter Bezugnahme auf die vorstehende Beschreibung des strukturellen Schaltungsaufbaus die Funktionsweise der erfindungsgemäßen Aktoranordnung erläutert.

Zur Verdeutlichung der Schaltungsfunktion sind in der folgenden Tabelle die Signale an den Meßeingängen I_{SENSE}, U_{SENSE} und IN_{SENSE}, die Stellung der Schalter SW1, SW2, SW3 sowie der Eingangswiderstand des Steuereingangs 4 für verschiedene Betriebszustände dargestellt. Die Bezeichnung "G" bedeutet hierbei, daß der entsprechende Schalter geschlossen ist, während die Bezeichnung "O" einem geöffneten Schalter entspricht.

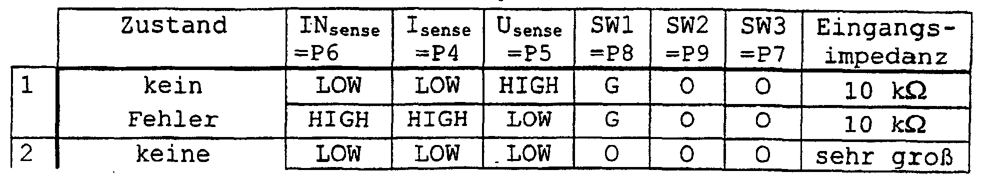

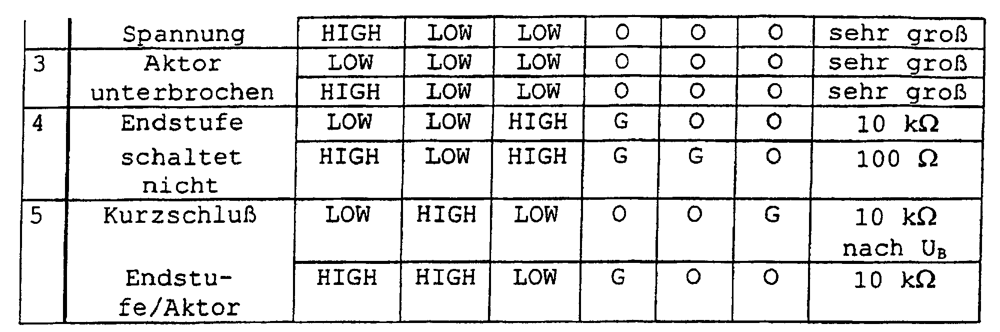

Es wird nun zunächst der fehlerfreie Betrieb der Aktoranordnung 1 beschrieben, der in den ersten beiden Zeilen der Tabelle dargestellt ist. Bei einer Aktivierung des Aktors durch die Motorsteuerung 2 gibt der Leitungstreiber 3 über die Steuerleitung 5 einen HIGH-Pegel auf den Steuereingang 4, der von dem Meßeingang IN_{SENSE} gemessen wird. Hierbei schaltet der Endstufen-Transistor 7 durch, so daß das Potential des Meßeingangs U_{SENSE} auf Massepotential abfällt und entsprechend einen LOW-Pegel annimmt. Im Gegensatz dazu nimmt der Meßeingang I_{SENSE} einen HIGH-Pegel an, da die Erregerspule 6 aufgrund des durchgeschalteten Endstufen-Transistors 7 stromdurchflossen ist. Die Ausgänge P4, P5 und P6 der Vergleichereinheit 9 und die Eingänge P1, P2 und P3 der Logikschaltung 10 nehmen dann entsprechend die Werte P4=P1=HIGH, P5=P2=LOW und P6=P3=HIGH an. Die Logikschaltung 10 bestimmt dann in Abhängigkeit von den an den Eingängen P1, P2 und P3 anliegenden Signalen entsprechend der folgenden Tabelle die Pegel der Ausgänge P7=P9=LOW und P8=HIGH, d.h. der Schalter SW1 ist geschlossen, während die Schalter SW2 und SW3 geschlossen sind.

Entsprechend ist der Eingangswiderstand R_{IN} des Steuereingangs 4 in diesem Betriebszustand R_{IN}=R1=10 kΩ.

| P1=P4 | P2=P5 | P3=P6 | P7 | P8 | P9 |
|---|---|---|---|---|---|
| LOW | LOW | LOW | LOW | LOW | LOW |
| LOW | LOW | HIGH | LOW | LOW | LOW |
| LOW | HIGH | LOW | LOW | HIGH | LOW |
| LOW | HIGH | HIGH | LOW | HIGH | HIGH |
| HIGH | LOW | LOW | HIGH | LOW | LOW |
| HIGH | LOW | HIGH | LOW | HIGH | LOW |
| HIGH | HIGH | LOW | egal | egal | egal |
| HIGH | HIGH | HIGH | egal | egal | egal |

Im inaktivierten, aber fehlerfreien Zustand liegt dagegen am Steuereingang 4 ein LOW-Pegel an, so daß der Endstufen-Transistor 7 sperrt. Dies hat zur Folge, daß der Meßeingang I_{SENSE} einen LOW-Pegel zeigt, da kein Strom durch die Erregerspule 6 fließt. Am Meßeingang U_{SENSE} erscheint dagegen die Batteriespannung und damit ein HIGH-Pegel, während der Meßeingang IN_{SENSE} das Steuersignal aufnimmt und deshalb ebenfalls einen LOW-Pegel annimmt. Die Eingänge der Logikschaltung 10 nehmen deshalb die logischen Werte P4=P1=LOW, P5=P2=HIGH und P6=P3=LOW an, so daß an den Ausgängen der Logikschaltung 10 nach obenstehender Tabelle die Werte P7=P9=LOW und P8=HIGH ausgegeben werden, d.h. der Schalter SW1 ist geschlossen, während die Schalter SW2 und SW3 geschlossen sind. Entsprechend ist der Eingangswiderstand R_{IN} des Steuereingangs 4 R_{IN}=R1-10 kΩ.

Im folgenden wird nun das Betriebsverhalten der Aktoranordnung 1 bei einem Ausfall der Batteriespannung beschrieben. In diesem Fall erscheint an den Ausgängen P7, P8 und P9 der Logikschaltung 10 aufgrund des Spannungsausfalls ein LOW-Pegel, so daß alle Schalter SW1, SW2 und SW3 geöffnet sind. Dementsprechend ist der Eingangswiderstand R_{IN} des Steuereingangs 4 gleich dem Eingangswiderstand des Endstufentransistors, d.h. sehr hochohmig.

Falls dagegen die Erregerspule 6 unterbrochen ist, so kann kein Strom durch die Erregerspule 6 fließen, und der Meßeingang I_{SENSE} nimmt stets einen LOW-Pegel an. Weiterhin liegt der Meßeingang U_{SENSE} in diesem Fehlerfall stets auf Massepotential und nimmt damit einen LOW-Pegel an. An den Eingängen der Logikschaltung 10 liegen somit die Signale P1=LOW, P2=LOW, während der Eingang P3 vom Steuereingang 4 abhängt. Die Logikschaltung 10 berechnet daraus nach der vorstehenden Tabelle die Ausgangssignale P7=P8=P9=LOW, so daß alle Schalter SW1, SW2 und SW3 geöffnet sind. Der Eingangswiderstand am Steuereingang 4 ist in diesem Fall wie bei dem vorstehend beschriebenen Verlust der Batteriespannung sehr hochohmig.

Im folgenden wird nun das Betriebsverhalten der Aktoranordnung 1 für den Fehlerfall beschrieben, daß der Endstufen-Transistor 7 nicht mehr durchschaltet. In diesem Fall liegt der Meßeingang U_{SENSE} stets auf Batteriespannung und damit HIGH-Potential, während der Meßeingang I_{SENSE} ein LOW-Potential annimmt, da kein Strom mehr durch die Erregerspule 6 fließen kann. An den Eingängen der Logikschaltung 10 erscheinen also in diesem Fehlerfall die Signale P1=P4=LOW und P2=P5=HIGH, während das Eingangssignal P3 von der Ansteuerung durch die Motorsteuerung 2 abhängt. Entsprechend der vorstehenden Logiktabelle erscheint dann an den Ausgängen P8=HIGH und P7=LOW, so daß der Schalter SW1 schließt, während der Schalter SW3 geöffnet ist. Die Stellung des Schalters SW2 ist dagegen in diesem Fall von der Ansteuerung durch die Motorsteuerung abhängig. Bei einem Steuersignal IN_{SENSE}=LOW erscheint am Eingang P3 der Logikschaltung 10 ebenfalls ein LOW-Pegel, so daß am Ausgang P9 der Logikschaltung 10 ein LOW-Pegel erscheint und der Schalter SW2 geöffnet ist. Der Eingangswiderstand R_{IN} der Aktoranordnung 1 ist in diesem Fehlerfall gleich dem Widerstand R1=10 kΩ. Bei einer Ansteuerung der Aktoranordnung 1 durch die Motorsteuerung 2 nimmt der Meßeingang IN_{SENSE} dagegen einen HIGH-Pegel an, so daß auch am Eingang P3 der Logikschaltung 10 ein HIGH-Pegel anliegt. Der Ausgang P9 der Logikschaltung 10 nimmt dann entsprechend der obigen Logiktabelle einen HIGH-Pegel an, so daß auch der Schalter SW2 schließt. Der Innenwiderstand R_{IN} an dem Steuereingang 4 ist dann im wesentlichen gleich dem Widerstand R2=100 Ω.

Schließlich wird nun der Fehlerfall beschrieben, bei dem der Endstufen-Transistor 7 einen Kurzschluß oder die Erregerspule 6 einen Masseschluß aufweist. In diesem Fall liegt der Meßeingang U_{SENSE} auf Massepotential, so daß am Ausgang P5 der Vergleichereinheit 9 und am Eingang P2 der Logikschaltung 10 ein LOW-Pegel anliegt. Wegen des Kurzschlusses in dem Endstufen-Transistor 7 liegt der Meßeingang I_{SENSE} auf HIGH-Potential, so daß auch am Ausgang P4 der Vergleichereinheit 9 und am Eingang P1 der Logikschaltung 10 ein HIGH-Potential erscheint, während das Signal am Eingang P3 der Logikschaltung 10 von der Ansteuerung durch die Motorsteuerung 2 abhängt. Bei einem HIGH-Pegel auf der Steuerleitung 5 erscheint auch am Eingang P3 der Logikschaltung 10 ein HIGH-Pegel, so daß die Ausgänge der Logikschaltung 10 die Werte P9=LOW, P8=HIGH und P7=LOW annehmen. Dementsprechend ist der Schalter SW1 geschlossen, während die Schalter SW2 und SW3 geöffnet sind. Der Eingangswiderstand R_{IN} an dem Steuereingang 4 beträgt dann R_{IN}=10 kΩ. Bei einem LOW-Pegel auf der Steuerleitung 5 erscheint dagegen an dem Meßeingang IN_{SENSE} und damit auch an dem Eingang P3 der Logikschaltung 10 ein LOW-Pegel. Die Ausgänge der Logikschaltung 10 nehmen dann die Werte P9=LOW, P7=HIGH und P8=LOW, so daß der Schalter SW3 geschlossen ist, während die Schalter SW1 und SW2 geöffnet sind. An dem Steuereingang 4 liegt dann über den Eingangswiderstand R_{IN}=R1=10 kΩ die Batteriespannung U_{B} an.

Der Eingangswiderstand R_{IN} an dem Steuereingang 4 bzw. die Spannung an dem Steuereingang 4 hängt somit vom Betriebszustand der Aktoranordnung 1 ab, so daß die Motorsteuerung 2 durch Überwachung der Steuerleitung 5 den Betriebszustand der Aktoranordnung 1 ohne zusätzliche Leitungen ermitteln kann.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Aktoranordnung (1), insbesondere zur Ansteuerung eines Einspritzventils einer Brennkraftmaschine, mit
einem elektrisch aktivierbaren Aktor (6),
einem Leistungsschalter (7) zur Aktivierung des Aktors (6),
einem Steuereingang (4) zur Aufnahme eines Steuersignals für die Ansteuerung des Leistungsschalters (7) von einer externen Steuereinheit (2, 3) über eine Steuerleitung (5),
einer eingangsseitig mit dem Aktor (6) und/oder dem Leistungsschalter (7) verbundenen Diagnoseschaltung (8) zur Erfassung des Betriebszustands,
**dadurch gekennzeichnet,**
**daß** der Steuereingang (4) mit mindestens einem ersten Schaltelement (SW1, SW2, SW3) verbunden ist, um das elektrische Eingarigsverhalten zu beeinflussen,
und
**daß** die Diagnoseschaltung (8) ausgangsseitig mit dem ersten Schaltelement (SW1, SW2, SW3) verbunden ist, um das Eingangsverhalten in Abhängigkeit von dem Betriebszustand zu beeinflussen und dadurch über die Steuerleitung (5) eine Ferndiagnose durch die externe Steuereinheit (2, 3) zu ermöglichen.

2. Aktoranordnung (1) nach Anspruch 1,
**dadurch gekennzeichnet,**
**daß** das erste Schaltelement (SW1) den Steuereingang (4) über einen ersten Widerstand (R1) mit Masse verbindet.

3. Aktoranordnung (1) nach Anspruch 2,
**gekennzeichnet durch**
ein zweites Schaltelement (SW2), das den Steuereingang (4) über einen zweiten Widerstand (R2) mit Masse verbindet.

4. Aktoranordnung (1) nach Anspruch 3,
**dadurch gekennzeichnet,**
**daß** der zweite Widerstand (R2) wesentlich kleiner ist als der erste Widerstand (R1).

5. Aktoranordnung (1) nach einem der vorhergehenden Ansprüche,
**gekennzeichnet durch**
ein drittes Schaltelement (SW3), das den Steuereingang (4) über einen dritten Widerstand (R1) mit der Versorgungsspannung verbindet.

6. Aktoranordnung (1) nach einem der vorhergehenden Ansprüche,
**dadurch gekennzeichnet,**
**daß** die Diagnoseschaltung (8) eine Logikschaltung (10) mit mehreren digitalen Eingängen (P1, P2, P3) und Ausgängen (P7, P8, P9) und zur Ansteuerung der Logikschaltung (10) eine Vergleichereinheit (9) mit mehreren analogen Eingängen (IN_{SENSE}, U_{SENSE}, I_{SENSE}) und mehreren digitalen Ausgängen (P4, P5, P6) aufweist,
wobei die analogen Eingänge (IN_{SENSE}, U_{SENSE}, I_{SENSE}) der Vergleichereinheit (9) mit dem Aktor (6) und dem Leistungsschalter (7) verbunden sind, um den Betriebszustand zu erfassen,
während die digitalen Ausgänge (P7, P8, P9) der Logikschaltung (10) mit jeweils einem der Schaltelemente (SW1, SW2, SW3) verbunden sind, um das Eingangsverhalten an dem Steuereingang (4) zu beeinflussen.

## Claims

1. Actuator arrangement (1), in particular for actuating an injection valve of an internal combustion engine, having
an actuator (6) which can be activated electrically,
a power switch (7) for activating the actuator (6),
a control input (4) for receiving a control signal for actuating the power switch (7) from an external control unit (2, 3) via a control line (5),
a diagnostic circuit (8) which is connected at the input end to the actuator (6) and/or to the power switch (7), for sensing the operating state, **characterized in that** the control input (4) is connected to at least one first switch element (SW1, SW2, SW3) in order to influence the electrical input characteristics, and **in that** the diagnostic circuit (8) is connected at the output end to the first switch element (SW1, SW2, SW3) in order to influence the input characteristics as a function of the operating state and as a result permit remote diagnostics by means of the external control unit (2, 3) via the control line (5).

2. Actuator arrangement (1) according to Claim 1,
**characterized in that** the first switch element (SW1) connects the control input (4) to earth via a first resistor (R1).

3. Actuator arrangement according to Claim 2, **characterized by** a second switch element (SW2) which connects the control input (4) to earth via a second resistor (R2).

4. Actuator arrangement (1) according to Claim 3, **characterized in that** the second resistor (R2) is significantly smaller than the first resistor (R1).

5. Actuator arrangement (1) according to one of the preceding claims, **characterized by** a third switch element (SW3) which connects the control input (4) to the supply voltage via a third resistor (R1).

6. Actuator arrangement (1) according to one of the preceding claims, **characterized in that** the diagnostic circuit (8) has a logic circuit (10) with a plurality of digital inputs (P1, P2, P3) and outputs (P7, P8, P9), and for driving the logic circuit (10) a comparator unit (9) with a plurality of analogue inputs (IN_{SENSE}, U_{SENSE}, I_{SENSE}) and a plurality of digital outputs (P4, P5, P6),
the analogue inputs (IN_{SENSE}, U_{SENSE}, I_{SENSE}) of the comparator unit (9) being connected to the actuator (6) and to the power switch (7) in order to sense the operating state,
while the digital outputs (P7, P8, P9) of the logic circuit (10) are connected to, in each case, one of the switching elements (SW1, SW2, SW3) in order to influence the input characteristics on the control input (4).

## Revendications

1. Dispositif à acteurs (1), en particulier pour la commande d'une soupape d'injection d'un moteur à combustion interne, comprenant
un acteur (6) pouvant être activé électriquement,
un interrupteur de puissance (7) prévu pour l'activation de l'acteur (6),
une entrée de commande (4) destinée à recevoir un signal de commande pour la commande de l'interrupteur de puissance (7) en provenance d'une entrée de commande externe (2, 3) par l'intermédiaire d'une ligne de commande (5),
un circuit de diagnostic (8) relié, côté entrée, à l'acteur (6) et/ou à l'interrupteur de puissance (7), qui est destiné à détecter l'état de fonctionnement,
**caractérisé**
**en ce que** l'entrée de commande (4) est reliée à au moins un premier élément de circuit (SW1, SW2, SW3) pour influer sur le comportement d'entrée électrique,
et
**en ce que** le circuit de diagnostic (8) est relié, côté sortie, au premier élément de commutation (SW1, SW2, SW3), pour influer sur le comportement d'entrée en fonction de l'état de fonctionnement et pour permettre par ce moyen de faire exécuter un télédiagnostic par l'entrée de commande extérieure (2, 3) au moyen de la ligne de commande (5).

2. Dispositif à acteurs (1) selon la revendication 1,
**caractérisé**
**en ce que** le premier élément de circuit (SW1) relie l'entrée de commande (4) à la masse à travers une première résistance (R1).

3. Dispositif à acteurs (1) selon la revendication 2,
**caractérisé**
**par** un deuxième élément de circuit (SW2) qui relie l'entrée de commande (4) à la masse à travers une deuxième résistance (R2).

4. Dispositif à acteurs (1) selon la revendication 3,
**caractérisé**
**en ce que** la deuxième résistance (R2) est sensiblement plus petite que la première résistance (R1).

5. Dispositif à acteurs (1) selon une des revendications précédentes,
**caractérisé**
**par** un troisième élément de circuit (SW3) qui relie l'entrée de commande (4) à la tension d'alimentation à travers une troisième résistance (R1).

6. Dispositif à acteurs (1) selon une des revendications précédentes,
**caractérisé**
**en ce que** le circuit de diagnostic (8) comprend un circuit logique (10) possédant plusieurs entrées numériques (P1, P2, P3) et plusieurs sorties numériques (P7, P8, P9) et, pour la commande du circuit logique (10), une unité de comparaison (9) possédant plusieurs entrées analogiques (IN_{SENSE}, U_{SENSE}, I_{SENSE}) et plusieurs sorties numériques (P4, P5, P6),
les entrées analogiques (IN_{SENSE}, U_{SENSE}, I_{SENSE}) de l'unité de comparaison (9) étant reliées à l'acteur (6) et à l'interrupteur de puissance (7) pour détecter l'état de fonctionnement,
tandis que les sorties numériques (P7, P8, P9) du circuit logique (10) sont reliées chacune avec un des éléments de circuit (SW1, SW2, SW3) pour influer sur le comportement d'entrée à l'entrée de commande (4).
